(19) Europäisches Patentamt
European Patent Office
Office européen des brevets

(11) **EP 0 899 880 B1**

(12) **EUROPÄISCHE PATENTSCHRIFT**

(45) Veröffentlichungstag und Bekanntmachung des Hinweises auf die Patenterteilung:
**19.03.2003  Patentblatt 2003/12**

(51) Int Cl.$^7$: **H03K 3/356**

(21) Anmeldenummer: **98112140.3**

(22) Anmeldetag: **30.06.1998**

(54) **Pegelwandler**

Level converter

Convertisseur de niveau

(84) Benannte Vertragsstaaten:
**DE FR GB**

(30) Priorität: **23.07.1997  DE 19731704**

(43) Veröffentlichungstag der Anmeldung:
**03.03.1999  Patentblatt 1999/09**

(73) Patentinhaber: **Infineon Technologies AG**
**81669 München (DE)**

(72) Erfinder:
- **Latzel, Thomas, Dr.**
  **81549 München (DE)**
- **Sporrer, Christian, Dr.**
  **82194 Gröbenzell (DE)**

(74) Vertreter: **Reinhard - Skuhra - Weise & Partner**
**Postfach 44 01 51**
**80750 München (DE)**

(56) Entgegenhaltungen:
EP-A- 0 739 094          US-A- 4 216 390
US-A- 5 245 228          US-A- 5 510 748

- **PATENT ABSTRACTS OF JAPAN vol. 1996, no. 06, 28. Juni 1996 (1996-06-28) -& JP 08 051351 A (TOSHIBA CORP), 20. Februar 1996 (1996-02-20) -& US 5 825 205 A (OHTSUKA NOBUAKI) 20. Oktober 1998 (1998-10-20)**

**Beschreibung**

Die Erfindung betrifft einen Pegelwandler zur Wandlung zweier Eingangspotentiale in zwei Ausgangspotentiale. Die Schaltung soll in integrierter Schaltungstechnik ausführbar sein.

In einer herkömmlichen Pegelwandlerschaltung wird der Pegel mit Hilfe von Referenzdioden gewandelt. Nachteilhaft bei dieser Schaltung, die über die Dioden eine Referenzspannung erzeugt, ist die ständige Stromaufnahme. Diese Referenzspannung ist stark temperatur- und technologieabhängig. Herkömmlicherweise werden Transistoren verwendet, die als Dioden arbeiten. Dadurch ist die Referenzspannung abhängig von der Schwellenspannung der Transistoren und damit von der Technologie.

Die Aufgabe der Erfindung ist es, einen Pegelwandler anzugeben, bei dem die oben genannten Nachteile nicht auftreten, d.h. die Schaltung ist technologieunabhängig und damit in integrierter Schaltungstechnik realisierbar. Weiterhin soll der Pegelwandler stromlos arbeiten.

Die Aufgabe der Erfindung wird durch einen Pegelwandler gemäß Patentanspruch 1 gelöst.

Vorteilhafte Weiterbildungen ergeben sich aus den abhängigen Ansprüchen.

Der erfindungsgemäße Pegelwandler weist eine erste Gegentakteingangsstufe sowie einen ersten und einen zweiten Transistor auf. Der erste Eingang der ersten Gegentakteingangsstufe ist mit dem Pegelwandlereingang und der Ausgang der ersten Gegentakteingangsstufe mit dem Steuereingang des ersten Transistors verbunden. Der zweite Ausgang der ersten Gegentakteingangsstufe ist mit dem Pegelwandlerausgang, dem ersten Ausgang des ersten Transistors und dem ersten Ausgang des zweiten Transistors verbunden. Der zweite Eingang der ersten Gegentakteingangsstufe und der zweite Ausgang des ersten Transistors ist mit einem ersten Potential verbunden, während der zweite Ausgang des zweiten Transistors mit einem zweiten Potential verbunden ist. Der Steuereingang des zweiten Transistors ist mit dem invertierten Pegelwandlerausgang verbunden. Die auf die oben genannte Art verknüpften Schaltungselemente sind Bestandteil eines ersten Schaltungszweigs des Pegelwandlers. Im folgenden wird dieser Schaltungszweig auch als 1. Gegentaktzweig GZ bezeichnet. Ein zweiter Schaltungszweig (2. Gegentaktzweig GZ') des Pegelwandlers weist einen Inverter, eine zweite Gegentakteingangsstufe, einen dritten und einen vierten Transistor auf. Der erste Eingang der zweiten Gegentakteingangsstufe ist über den Inverter mit dem Pegelwandlereingang und der erste Ausgang der zweiten Gegentakteingangsstufe mit dem Steuereingang des dritten Transistors verbunden. Der zweite Ausgang der zweiten Gegentakteingangsstufe ist mit dem invertierten Pegelwandlerausgang, dem ersten Ausgang des dritten Transistors und dem ersten Ausgang des vierten Transistors verbunden. Der zweite Eingang der zweiten Gegentakteingangsstufe und der zweite Ausgang des dritten Transistors sind mit dem ersten Potential und der Ausgang des vierten Transistors mit dem zweiten Potential verbunden. Schließlich ist der Steuereingang des vierten Transistors mit dem nicht invertierten Pegelwandlerausgang verbunden.

Die erste Gegentakteingangsstufe des erfindungsgemäßen Pegelwandlers weist zwei ausgangsseitig, in Reihe geschaltete Transistoren auf, deren Steuereingänge miteinander verbunden sind und die den zweiten Eingang der ersten Gegentakteingangsstufe bilden. Die beiden Transistorausgänge der ersten Gegentakteingangsstufe, die miteinander verbunden sind, bilden den ersten Ausgang der ersten Gegentakteingangsstufe. Ein weiterer Ausgang der Transistoren bildet den zweiten Ausgang der ersten Gegentakteingangsstufe. Die Steuereingänge der beiden Transistoren der ersten Gegentakteingangsstufe bilden den zweiten Eingang der ersten Gegentakteingangsstufe.

Die beiden Transistoren der Gegentakteingangsstufe sind Feldeffekttransistoren, wobei der erste Transistor ein n-Kanalund der zweite Transistor ein p-Kanal-Transistor ist.

Die zweite Gegentakteingangsstufe entspricht dem Aufbau der ersten.

Der Inverter ist unsymmetrisch dimensioniert, um zu erreichen, daß die Gegentakteingangsstufen symmetrisch angesteuert werden.

Im folgenden wird die Erfindung anhand einer Figur weiter erläutert.

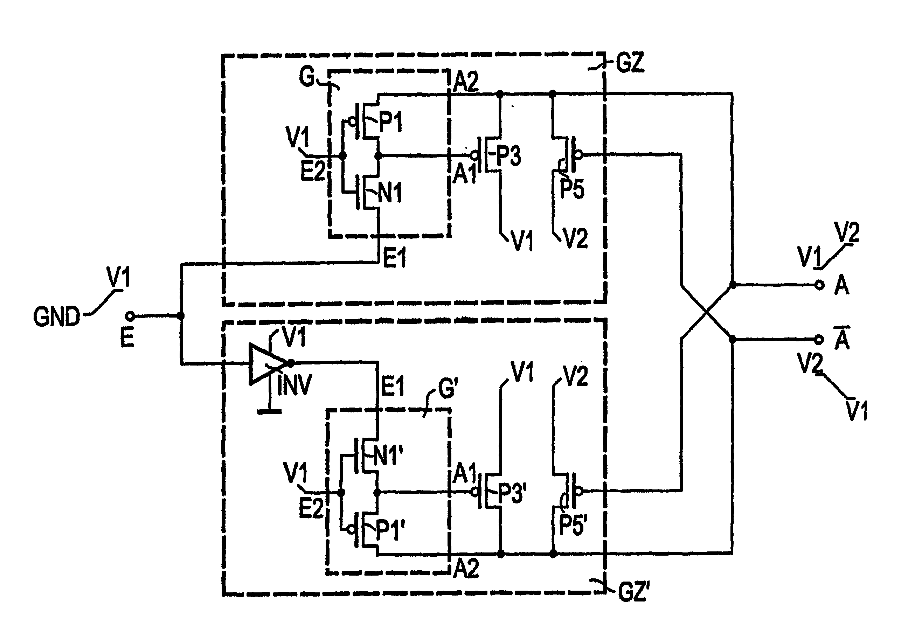

Die Figur zeigt den Aufbau des erfindungsgemäßen Pegelwandlers.

Am Eingang E des Pegelwandlers liegt entweder der Pegel GND oder V1 an. Dieser ist mit dem ersten Eingang einer ersten Gegentakteingangsstufe G verbunden. Die erste Gegentakteingangsstufe G ist ausgangsseitig einerseits mit dem Steuereingang eines Transistors P3 und andererseits mit dem ersten Ausgang des Transistors P3, dem ersten Ausgang eines Transistors P5 und dem Pegelwandlerausgang A verbunden. Der zweite Ausgang des Transistors P3 und der zweite Eingang der ersten Gegentakteingangsstufe G führen auf einen ersten Pegel V1 und der zweite Ausgang des Transistors P5 auf einen Pegel V2. Der Steuereingang des Transistors P5 ist mit dem invertierten Pegelwandlerausgang Ā verbunden. Die oben genannten Schaltelemente bilden einen ersten Schaltungszweig (auch als erster Gegentaktzweig GZ bezeichnet) des Pegelwandlers. Ein zweiter Schaltungszweig (= zweiter Gegentaktzweig GZ') des Pegelwandlers ist ausgangsseitig mit dem ersten Schaltungszweig kreuzweise gekoppelt. Der zweite Schaltungszweig weist zusätzlich eingangsseitig einen Inverter INV auf. Dessen Eingang ist mit dem Pegelwandlereingang E verbunden. Der Ausgang des Inverters INV führt auf den ersten Eingang der zweiten Gegentakteingangsstufe G', deren erster Ausgang mit dem Steuereingang eines Transistors P3' verbunden ist. Der zweite Ausgang der zweiten Gegentakteingangsstufe G' führt auf den invertierten Pegelwandlerausgang $\overline{A}$, den ersten Ausgang des Transistors P3' und den ersten Ausgang eines Transistors P5'. Mit dem ersten Pegel V1 sind der Ausgang des Transistors P3', der zweite Eingang der zweiten Gegentakteingangsstufe G' und die Spannungsversorgung des Inverters INV verbunden. Der zweite Ausgang des Transistors P5' liegt auf dem Pegel V2. Der Steuereingang des Transistors P5' ist mit dem Pegelwandlerausgang A verbunden.

Sowohl die erste als auch die zweite Gegentakteingangsstufe G, G' weisen zwei ausgangsseitig in Reihe geschaltete Transistoren P1, N1 bzw. P1', N1' auf , deren Steuereingänge miteinander verbunden sind und den zweiten Eingang der jeweiligen Gegentakteingangsstufe G bzw. G' bilden. Die beiden miteinander verbundenen Ausgänge der Transistoren P1, N1 bzw. P1', N1' und ein weiterer Ausgang der Transistoren P1, N1 bzw. P1', N1' bilden jeweils die beiden Ausgänge der Gegentakteingangsstufen G, G'. Die Ausgangsanschlüsse der Transistoren N1 und N1' bilden jeweils den ersten Eingang der Gegentakteingangsstufen G, G'. Die Transistoren N1 und N1' sind als n-Kanal-Feldeffekttransistoren ausgeführt, wohingegen die Transistoren P1, P1', P3, P3', P5 und P5' p-Kanal-Feldeffekttransistoren sind.

Der Inverter INV ist unsymmetrisch dimensioniert, um zu erreichen, daß die Gegentakteingangsstufen G, G' symmetrisch angesteuert werden. Am Pegelwandlerausgang $\overline{A}$ ist ein zum Pegelwandlerausgang A invertiertes Ausgangssignal abgreifbar.

Der erfindungsgemäße Pegelwandler ist so dimensioniert, daß nur während der Schaltvorgänge Umschaltströme fließen, nicht jedoch im Ruhezustand. Die Schaltung ist technologieunabhängig und rein digital ausgeführt.

Der Inverter INV dient zur Invertierung der am Pegelwandlereingang E anliegenden Eingangspegel GND und V1 in V1 bzw. GND. Liegt am Pegelwandlereingang E der Pegel GND an, so schaltet das Gate des Transistors N1 durch, d.h. der Transistor N1 leitet oder ist aktiv. Das Gate des Transistors P1 liegt ebenfalls an V1. Durch die Rückkopplung über den Transistor P3, der ebenfalls durchschaltet, wird der Transistor P1 gesperrt. Gleichzeitig wird der Transistor P5 durch das Ausgangssignal des zweiten Schaltungszweigs (= zweiter Gegentaktzweig GZ') gesperrt. Am Pegelwandlerausgang A liegt das Potential V1 bzw. V2 an.

Falls am Pegelwandlereingang E der Pegel V1 anliegt, sperrt der Transistor N1 (nicht aktiv). Das Gate des Transistors P1 liegt ebenso wie das des Transistors N1 auf dem Pegel V1. Durch das vom ersten Schaltungszweig (erster Gegentaktzweig G) erzeugte Ausgangssignal wird der Transistor P5 durchgeschaltet (aktiv, leitend) und damit der Transistor P1 durchgeschaltet und dadurch wiederum der Transistor P3 gesperrt. Am Pegelwandlerausgang A liegt dann der Pegel V2 bzw.

V1 an.

Alle Gate-Source-, Gate-Drain-, Drain-Source-Spannungen sind kleiner oder gleich dem Pegel V1.

**Patentansprüche**

1. Pegelwandler,

   - bei dem ein Pegelwandlereingang (E), ein Pegelwandlerausgang (A) und ein invertierter Pegelwandlerausgang ($\overline{A}$) vorgesehen sind,
   - bei dem eine erste Gegentakteingangsstufe (G) mit zwei Eingängen (E1, E2) und zwei Ausgängen (A1, A2), ein erster und ein zweiter Transistor (P3, P5) vorgesehen sind,
   - bei dem der erste Eingang (E1) der ersten Gegentakteingangsstufe (G) mit dem Pegelwandlereingang (E) und der erste Ausgang (A1) der ersten Gegentakteingangsstufe (G) mit dem Steuereingang des ersten Transistors (P3) verbunden ist,
   - bei dem der zweite Ausgang (A2) der ersten Gegentakteingangsstufe (G) mit dem Pegelwandlerausgang (A), dem ersten Ausgang des ersten Transistors (P3) und dem ersten Ausgang des zweiten Transistors (P5) verbunden ist,
   - bei dem ein Inverter (INV), eine zweite Gegentakteingangsstufe (G') mit zwei Eingängen (E1, E2) und zwei Ausgängen (A1, A2), ein dritter und ein vierter Transistor (P3', P5') vorgesehen sind,
   - bei dem der erste Eingang (E1) der zweiten Gegentakteingangsstufe (G') über den Inverter (INV) mit dem Pegelwandlereingang (E) und der erste Ausgang (A1) der zweiten Gegentakteingangsstufe (G') mit dem Steuereingang des dritten Transistors (P3') verbunden ist,
   - bei dem der zweite Ausgang (A2) der zweiten Gegentakteingangsstufe (G') mit dem invertierten Pegelwandlerausgang ($\overline{A}$), dem ersten Ausgang des dritten Transistors (P3') und dem ersten Ausgang des vierten Transistors (P5') verbunden ist,
   - bei dem die zweiten Eingänge (E2) der ersten und zweiten Gegentakteingangsstufe (G, G') und die zweiten Ausgänge des ersten und dritten Transistors (P3, P3') mit einem ersten Potential (V1) verbunden sind,
   - bei dem die zweiten Ausgänge des zweiten und vierten Transistors (P5, P5') mit einem zweiten Potential (V2) verbunden sind, und
   - bei dem der Steuereingang des zweiten Transistors (P5) mit dem invertierten Pegelwandlerausgang ($\overline{A}$) und der Steuereingang des vierten Transistors (P5') mit dem Pegelwandlerausgang (A) verbunden sind.

**2.** Pegelwandler nach Anspruch 1,

- bei dem jede Gegentakteingangsstufe (G, G') zwei ausgangsseitig in Reihe geschaltete Transistoren (P1, N1; P1', N1') aufweist, deren Steuereingänge miteinander und mit dem zweiten Eingang (E2) der Gegentakteingangsstufe (G, G') verbunden sind
- bei dem die beiden miteinander verbundenen Ausgänge der in Reihe geschalteten Transistoren (P1, N1; P1', N1') den ersten Ausgang (A1) der Gegentakteingangsstufe (G, G') bilden,
- bei dem ein weiterer Ausgang der in Reihe geschalteten Transistoren (P1, N1; P1', N1') den zweiten Ausgang (A2) der Gegentakteingangsstufe (G, G') bildet, und
- bei dem ein weiterer Ausgang der in Reihe geschalteten Transistoren (P1, N1; P1', N1') den ersten Eingang (E1) der Gegentakteingangsstufe (G, G') bildet.

**3.** Pegelwandler nach einem der Ansprüche 1 oder 2,

- bei dem die Transistoren Feldeffekttransistoren sind.

**4.** Pegelwandler nach Anspruch 2,

- bei dem der eine Transistor (P1; P1') der Gegentakteingangsstufen (G, G') ein p-Kanal-Transistor und der andere Transistor (N1; N1') der Gegentakteingangsstufen (G, G') ein n-Kanal-Transistor ist.

**5.** Pegelwandler nach einem der Ansprüche 1 bis 4,

- bei dem der erste, zweite, dritte und vierte Transistor (P3, P3', P5, P5') p-Kanal Transistoren sind.

**6.** Pegelwandler nach einem der Ansprüche 1 bis 5,

- bei dem der Inverter (INV) unsymmetrisch dimensioniert ist, damit die Gegentakteingangsstufen (G, G') symmetrisch angesteuert werden.

**7.** Pegelwandler nach einem der Ansprüche 1 bis 6,

- bei dem die Gate-Source-, Gate-Drain- und Drain-Source-Spannungen der Transistoren (P1, N1, P1', N1', P3, P3', P5, P5') kleiner oder gleich dem ersten Potential (V1) sind.

**Claims**

**1.** Level converter,

- in which a level converter input (E), a level converter output (A) and an inverted level converter output ($\overline{\text{A}}$) are provided,
- in which a first push-pull input stage (G) having two inputs (E1, E2) and two outputs (A1, A2) and a first and a second transistor (P3, P5) are provided,
- in which the first input (E1) of the first push-pull input stage (G) is connected to the level converter input (E), and the first output (A1) of the first push-pull input stage (G) is connected to the control input on the first transistor (P3),
- in which the second output (A2) of the first push-pull input stage (G) is connected to the level converter output (A), to the first output of the first transistor (P3) and to the first output of the second transistor (P5),
- in which an inverter (INV), a second push-pull input stage (G') having two inputs (E1, E2) and two outputs (A1, A2) and a third and a fourth transistor (P3', P5') are provided,
- in which the first input (E1) of the second push-pull input stage (G') is connected to the level converter input (E) via the inverter (INV), and the first output (A1) of the second push-pull input stage (G') is connected to the control input on the third transistor (P3'),
- in which the second output (A2) of the second push-pull input stage (G') is connected to the inverted level converter output (A), to the first output of the third transistor (P3') and to the first output of the fourth transistor (P5'),
- in which the second inputs (E2) of the first and second push-pull input stages (G, G') and the second outputs of the first and third transistors (P3, P3') are connected to a first potential (V1),
- in which the second outputs of the second and fourth transistors (P5, P5') are connected to a second potential (V2), and
- in which the control input on the second transistor (P5) is connected to the inverted level converter output ($\overline{\text{A}}$), and the control input on the fourth transistor (P5') is connected to the level converter output (A).

**2.** Level converter according to Claim 1,

- in which each push-pull input stage (G, G') has two transistors (P1, N1; P1', N1') whose outputs are connected in series and whose control inputs are connected to one another and to the second input (E2) of the push-pull input stage (G, G'),
- in which the two interconnected outputs of the series-connected transistors (P1, N1; P1', N1') form the first output (A1) of the push-pull input stage (G, G'),
- in which a further output of the series-connected transistors (P1, N1; P1', N1') forms the second output (A2) of the push-pull input stage (G, G'), and

- in which a further output of the series-connected transistors (P1, N1; P1', N1') forms the first input (E1) of the push-pull input stage (G, G').

3. Level converter according to one of Claims 1 or 2,

- in which the transistors are field-effect transistors.

4. Level converter according to Claim 2,

- in which one transistor (P1; P1') in the push-pull input stages (G, G') is a p-channel transistor, and the other transistor (N1; N1') in the push-pull input stages (G, G') is an n-channel transistor.

5. Level converter according to one of Claims 1 to 4,

- in which the first, second, third and fourth transistors (P3, P3', P5, P5') are p-channel transistors.

6. Level converter according to one of Claims 1 to 5,

- in which the inverter (INV) is of asymmetric design so that the push-pull input stages (G, G') are actuated symmetrically.

7. Level converter according to one of Claims 1 to 6,

- in which the gate-source, gate-drain and drain-source voltages of the transistors (P1, N1, P1', N1', P3, P3', P5, P5') are less than or equal to the first potential (V1).


**Revendications**

1. Convertisseur de niveau,

- dans lequel il est prévu une entrée (E) du convertisseur de niveau, une sortie (A) du convertisseur de niveau et une sortie inversée ($\bar{A}$) du convertisseur de niveau,
- dans lequel il est prévu un premier étage d'entrée symétrique (G) avec deux entrées (E1, E2) et deux sorties (A1, A2), un premier et un deuxième transistors (P3, P5),
- dans lequel la première entrée (E1) du premier étage d'entrée symétrique (G) est connectée à l'entrée (E) du convertisseur de niveau et la première sortie (A1) du premier étage d'entrée symétrique (G) est connectée à l'entrée de commande du premier transistor (P3),

- dans lequel la seconde sortie (A2) du premier étage d'entrée symétrique (G) est connectée à la sortie (A) du convertisseur de niveau, à la première sortie du premier transistor (P3) et à la première sortie du deuxième transistor (P5),
- dans lequel il est prévu un inverseur (INV), un second étage d'entrée symétrique (G') avec deux entrées (E1, E2) et deux sorties (A1, A2), un troisième et un quatrième transistors (P3', P5'),
- dans lequel la première entrée (E1) du second étage d'entrée symétrique (G') est connectée via l'inverseur (INV) à l'entrée (E) du convertisseur de niveau et la première sortie (A1) du second étage d'entrée symétrique (G') est connectée à l'entrée de commande du troisième transistor (P3'),
- dans lequel la seconde sortie (A2) du second étage d'entrée symétrique (G') est connectée à la sortie inversée ($\bar{A}$) du convertisseur de niveau, à la première sortie du troisième transistor (P3') et à la première sortie du quatrième transistor (P5'),
- dans lequel les secondes entrées (E2) des premier et second étages d'entrée symétriques (G, G') et les secondes sorties des premier et troisième transistors (P3, P5) sont connectées à un premier potentiel (V1),
- dans lequel les secondes sorties des deuxième et quatrième transistors (P5, P5') sont connectées à un second potentiel (V2), et
- dans lequel l'entrée de commande du deuxième transistor (P5) est connectée à la sortie inversée ($\bar{A}$) du convertisseur de niveau et l'entrée de commande du quatrième transistor (P5') à la sortie (A) du convertisseur de niveau.

2. Convertisseur de niveau selon la revendication 1,

- dans lequel chaque étage d'entrée symétrique (G, G') présente deux transistors (P1, N1; P1', N1') commutés en série côté sortie, dont les entrées de commande sont connectées l'une à l'autre et à la seconde entrée (E2) de l'étage d'entrée symétrique (G, G'),
- dans lequel les deux sorties - connectées l'une à l'autre - des transistors (P1, N1; P1', N1') commutés en série forment la première sortie (A1) de l'étage d'entrée symétrique (G, G'),
- dans lequel une autre sortie des transistors (P1, N1; P1', N1') commutés en série forme la seconde sortie (A2) de l'étage d'entrée symétrique (G, G'), et
- dans lequel une autre sortie des transistors (P1, N1; P1', N1') commutés en série forme la première entrée (E1) de l'étage d'entrée symétrique (G, G').

3. Convertisseur de niveau selon l'une quelconque des revendications 1 ou 2, dans lequel les transistors sont des transistors à effet de champ.

4. Convertisseur de niveau selon la revendication 2,

   - dans lequel le premier transistor (P1; P1') des étages d'entrée symétriques (G, G') est un transistor à canal p et l'autre transistor (N1; N1') des étages d'entrée symétriques (G, G') est un transistor à canal n.

5. Convertisseur de niveau selon l'une quelconque des revendications 1 à 4,

   - dans lequel les premier, deuxième, troisième et quatrième transistors (P3, P3', P5, P5') sont des transistors à canal p.

6. Convertisseur de niveau selon l'une quelconque des revendications 1 à 5,

   - dans lequel l'inverseur (INV) est dimensionné de manière dissymétrique afin que les étages d'entrée symétriques (G, G') soient commandés symétriquement.

7. Convertisseur de niveau selon l'une quelconque des revendications 1 à 6,

   - dans lequel les tensions grille-source, grille-drain et drain-source des transistors (P1, N1, P1', N1', P3, P3', P5, P5') sont inférieures ou égales au premier potentiel (V1).